# EUROPEAN PATENT APPLICATION

(11) **EP 4 687 271 A1**
(43) Date of publication of application: **04.02.2026**
(21) Application number: 24191990.1
(22) Date of filing: 31.07.2024
(51) Int. Cl.: H02M 1/00, H02M 7/23, H02M 7/493, H02M 7/81

(54) **CURRENT SHARING OF PARALLEL-CONNECTED CONVERTERS**

(71) Applicant: ABB SCHWEIZ AG, 5400 Baden (CH)
(72) Inventor: Viitanen, Tero, 00380 Helsinki (FI); Leppänen, Veli-Matti, 00380 Helsinki (FI); Kittilä, Jukka-Pekka, 00380 Helsinki (FI)
(74) Representative: Kolster Oy Ab

(57) **Abstract**

In a power converter system, converter legs (INV1, INV2) are connected in parallel between a common dc system (4) and a common ac system (6) or between two common dc systems to provide respective leg currents (I_{ο1}, Iₒ₂). A gate driver circuitry is coupled to provide dedicated gate voltages to gates of controllable semiconductor switching devices (S₁₁, S₂₁, S₁₂, S₂₂) of parallel-connected converter legs. A control arrangement is configured to balance a current sharing between the parallel-connected converter legs (INV1, INV2) by means of having an individual autonomous leg-specific gate voltage adjustment for the semiconductor power switching devices of each of parallel connected converter legs in function of the leg current (Iₒ₁, I₀₂) or leg-current-related information of the respective converter leg.

## Description

### FIELD OF THE INVENTION

The present invention relates to parallel-connected power converters and more particularly to a current sharing of parallel-connected power converters.

### BACKGROUND OF THE INVENTION

In some situations, a power inverter with an increased output power capability is implemented by connecting a plurality of inverter units in parallel with one another to feed the same load. The parallel-connected inverter units may receive simultaneous and similar control signals to provide a desired output of the power inverter. However, due to parameter differences of switch components and differing impedances in parallel branches, the currents between the units can be unequal in magnitude. Such a current imbalance can stress the components unevenly and wear switch components with higher current prematurely. A higher current in a switch component can result in a higher dissipated power and, further, a higher temperature of the component.

Current imbalance has been addressed by modifying switch control pulses in order to balance the currents. The control pulses can be modified by delaying a turn-on time instant for a switch that has the highest current or by delaying turn-off time instants for a switch that has the smallest current. One such method is disclosed in EP0524398. In these solutions, the conducting times of the parallel components are modified to equalize stresses to the switch components on the basis of measured inverter unit currents.

US8432714 discloses a method for balancing load between parallel-connected inverter modules wherein temperatures of each output leg of each inverter module are determined and the switching instructions for one or more of the parallel inverter modules are modified for controlling the temperatures of the output legs.

WO2017/079125A1 discloses a method wherein the output voltages of all the parallel connected power devices are measured, and the measuring results are used for mitigating timing differences during output voltage state changes caused e.g. by gate driver circuit and switching component parameter tolerances.

US7068525 discloses a method of operating multiple parallel-connected inverters by regulating the individual currents of the inverters separately.

### BRIEF DESCRIPTION OF THE INVENTION

An object of the present invention is to provide an improved power converter system having two or more parallel-connected converter legs. The power converter system is recited in the independent claim. Preferred embodiments are disclosed in the dependent claims.

An aspect of the invention is a power converter system, comprising
two or more converter legs connected in parallel between a common dc system and a common ac system or between two common dc systems to provide respective two or more leg currents, wherein each of said converter legs comprises one or more controllable semiconductor power switching devices,
a gate driver circuitry coupled to provide dedicated gate voltages to gates of the controllable semiconductor power switching devices, and
a control arrangement configured to balance a current sharing between the parallel-connected converter legs by means of having an individual autonomous leg-specific gate voltage adjustment for the controllable semiconductor power switching devices of each of parallel connected converter legs in function of the leg current or leg-current-related information of the respective converter leg.

In embodiments, the autonomous gate voltage adjustment of each parallel-connected leg is configured to adjust the gate voltage in a direction and/or by an amount that the leg currents of the parallel-connected legs will change towards each other.

In embodiments, the autonomous gate voltage adjustment of each parallel-connected leg is configured to rely only on leg-current-related information that is available in the respective parallel-connected leg without information exchange between the autonomous gate voltage adjustments of the parallel-connected legs.

In embodiments, the autonomous gate voltage adjustment of each parallel-connected leg is configured to adjust the gate voltage inversely proportional to the leg-specific current or leg-current-related information.

In embodiments, the autonomous gate voltage adjustment of each parallel-connected leg is configured to decrease the gate voltage with increasing leg current and to increase the gate voltage with decreasing leg current.

In embodiments, the autonomous leg-specific gate voltage adjustments of all parallel-connected converter legs have the same first predetermined dependence on the value of the sensed leg current of the respective converter leg.

In embodiments, at least two of the parallel-connected converter legs have different nominal leg current ratings, and wherein the at least two parallel-connected converter legs with different nominal leg current ratings have different predetermined dependences on the value of the leg current of the respective converter leg that are configured to scale the current sharing between the between the at least two parallel-connected converter legs according to the nominal leg current ratings.

In embodiments, the leg current related information comprises a sensed leg current, or information derived or calculated from one or more other sensed quantities of the respective parallel-connected converter leg.

In embodiments, the autonomous gate voltage adjustment of each parallel-connected leg is configured to adjust the gate voltage in function of the leg current or leg-current-related information of the respective converter leg and further in function of one or more other parameters of the respective converter leg.

In embodiments, the autonomous gate voltage adjustment of each parallel-connected leg is configured to adjust the gate voltage differently in function of time.

In embodiments, the gate voltage may have pre-defined periods of different gate voltage levels.

In embodiments, the control arrangement is configured to set control dynamics, control range, activation and/or deactivation of the autonomous gate voltage adjustment dependent on system parameters.

In embodiments, the controllable semiconductor power switching devices comprises one or more of an insulated gate bipolar transistor (IGBT), a reverse conducting IGBT (RC-IGBT), metal-oxide-semiconductor field-effect transistor (MOSFET), or a silicon carbide (SiC) MOSFET.

In embodiments, the control arrangement comprises a leg-specific controller for each of the two or more parallel-connected converter legs to adjust the gate voltages.

In embodiments, each of the converter legs comprises one or more controllable semiconductor power switching devices in a full bridge configuration, a half bride configuration, or a chopper configuration.

In embodiments, the converter legs form a multi-level converter.

In embodiments, the power converter system comprises two or more converters, each of the converters comprising one or more converter legs, wherein the parallel-connected converter legs are the corresponding converter legs of the two or more converters connected in parallel.

In embodiments, the control arrangement comprises converter-specific switching controllers for the two or more converters, each of the converter-specific switching controllers being configured to provide the autonomous adjustment of the gate voltages for each of the converter legs of the respective converter.

### BRIEF DESCRIPTION OF THE DRAWINGS

In the following the invention will be described in greater detail by means of exemplary embodiments with reference to the attached drawings, in which
Figure 1 is a block diagram that schematically illustrates an exemplary inverter system having a plurality of parallel-connected inverters;
Figure 2 is a schematic of an exemplary inverter system having two parallel-connected hard-switching inverters;
Figure 3 is a schematic of an exemplary gate driving control using a bipolar voltage source and a gate resistor R_{g};
Figure 4 shows an example of IGBT switching waveforms in the turn-on of a power inverter;
Figure 5A shows an example of a typical collector-emitter voltage V_{ce} on the collector current I_{c} at different IGBT chip temperatures while the gate voltage V_{ge} is constant;
Figure 5B shows an example of a dependency of the collector-emitter voltage V_{ce} on the collector current I_{c} with different gate voltages V_{ge} while the chip temperature is constant;
Figure 6 shows a flow diagram illustrating an exemplary operation of the control arrangement;
Figures 7A, 7B and 7C are graphs that illustrate an exemplary behavior of the leg currents Iₒ₁ and I₀₂ with different gate voltages in function of the duration of the turn-on pulse of the gating signals applied to parallel-connected semiconductor switch modules;
Figure 8 is a schematic of an exemplary gate driver circuit using a resistor matrix;
Figure 9 is a schematic of an exemplary gate driver circuit using a pulse-width-modulation (PWM);
Figures 10A, 10B, 10C, 10D, 10E, and 10F show exemplary PWM signals for the gate voltage control; and
Figures 11A, 11B and 11C show some exemplary gate voltage waveforms illustrating the effect of the PWM control of gate voltage during a turn-on-switching of an IGBT.

### DETAILED DESCRIPTION

A dc-ac or ac-dc converter, also known as an inverter or a rectifier respectively, converts power from dc to ac or ac to dc power system at desired voltages and frequencies. Further, a dc-dc converter, such as a dc chopper, converts power from dc to dc power system. Although embodiments are described using inverters and inverter systems as examples, the invention is similarly applicable to rectifiers and rectifier systems as well as dc-dc converters. Inverter and rectifier can be exactly similar in structure and the control operations can be similar, the difference being the direction of a power flow. When a converter operates as an inverter (dc/ac converter), it converts the power from a dc system to an ac system, i.e., the ac side of the converter is referred as an output side and the dc side is considered as an input side. When a converter operates as a rectifier (ac/dc converter), it converts power from an ac system to a dc system, i.e., the ac side of the converter is considered as an input side and the dc side is considered as an output side. Further, connecting ac/dc and dc/ac converters in back-to-back configuration, i.e. dc-sides connected together, between two ac systems, one of the converters is operating in rectifier mode and the other in inverter mode, depending on the power flow direction. Operation modes of the converters may vary during the operation, as power flow may vary.

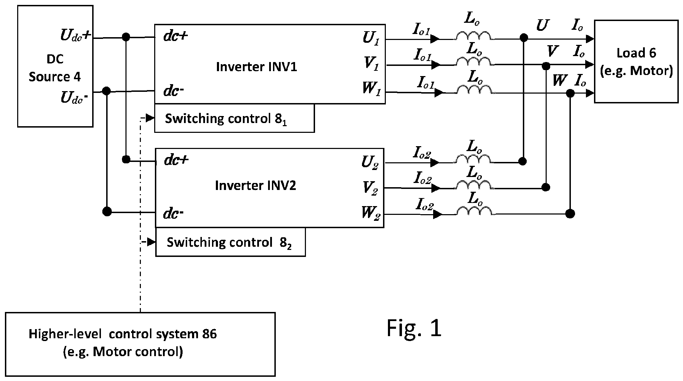

Fig. 1 shows a block diagram that schematically illustrates an exemplary inverter system having a plurality of (i.e., two or more) inverters INV1, INV2, ..., INVN connected in parallel from their DC side (e.g., DC link) terminals (e.g., dc+, dc-) and their AC side terminals (e.g., U₁, V₁, W₁, U₂, V₂, W₂). In the illustrated example, the inverters INV1 and INV2 are three-phase inverters providing three phase outputs U₁, V₁, W₁ and U₂, V₂, W₂, but it should be appreciated that parallel-connected inverters may be implemented as single-phase inverters, or generally include any number of inverter phases or phase legs. The parallel-connected inverters are fed by a common DC voltage source 4 with voltage U_{dc}, and inverters are feeding a common AC load 6. A typical application area of the parallel-connected inverters fed by a common DC voltage source 4 is an electric motor drive having an AC electric motor as a common load 6. There is a non-zero impedance at each phase output of each inverter, represented by inductances Lo in Fig. 1. The output inductances Lo may be intentionally implemented (e.g., a coil, a choke, etc.) or it may be just some leakage impedance of practical components and materials, such as cabling. The output inductances Lo may be substantially equal, but it must not necessarily be so. The corresponding phase outputs U₁, U₂, V₁, V₂, and W₁, W₂ of the parallel-connected inverters INV1 and INV2 are connected through the output inductances Lo to the common phase outputs U, V, and W, respectively. The corresponding phase outputs U₁, U₂, V₁, V₂, and W₁, W₂ of the parallel-connected inverters INV1 and INV2 may be connected together right after the output inductances Lo, and a single cable or multiple cables per phase U, V, and W may be used to connect the phase outputs to the load 6. Alternatively, each parallel-connected inverters INV1 and INV2 can be connected by means of its own cabling to the load 6, and the phase outputs U₁, U₂, V₁, V₂, and W₁, W₂ can be connected in parallel first at the terminals of the load 6. Output phase current Io of each phase U, V, W supplied to load 6 is formed by combining phase output currents Iₒ₁ and Iₒ₂ of the respective phase outputs U₁, U₂, V₁, V₂, and W₁, Wz of the parallel-connected inverters INV1 and INV2. The common DC supplied parallel-connected inverter modules INV1 and INV2 can be controlled to act like one high power inverter. This can be achieved by controlling the parallel inverter units with essentially the same control commands.

In embodiments, each inverter module INV1 and INV2 may have one or more bridge circuits (a full bridge or a half bridge), one bridge circuit for each inverter phase or phase leg. The bridge circuits of the same phase of different inverter modules are connected in parallel with one another. Each bridge circuit can include a plurality of controllable semiconductor switching elements or devices (e.g. insulated gate bipolar transistors (IGBTs) that operate in a switch mode, meaning that that they are controlled to transition from a blocking state (OFF state) to a conducting state (ON state), and vice-versa, by providing control pulses (often called switching control signals or gating signals) at a high switching frequency. In a PWM modulation scheme, the width of control pulses provided to the control inputs of the switching devices is varied to provide a desired output of the inverter. The parallel-connected inverter modules INV1 and INV2 may have a common switching control that provides switching signals or gating signals to operate switching devices of all inverter modules, or more preferably, each parallel-connected inverter module INV1 and INV2 may have a dedicated switching control unit 8₁ and 8₂ that provides switching signals or gating signals to operate switching devices of the respective inverter module, as illustrated in Fig. 1. Alternatively, the control may be distributed among a common switching control unit and inverter module-specific switching control units. In the latter cases, the inverter modules may be normal inverter modules (i.e., that can be used as single units) that can be connected in parallel as such. In embodiments, the switching control(s) 8₁ and 8₂ of the parallel-connected inverter modules INV1 and INV2 may be controlled by a higher-level control system 86 with simultaneous and essentially similar control signals or commands.

In embodiments, each inverter module INV1 and INV2 may have one or more chopper circuits instead of full or half bridges.

In embodiments, the inverter modules INV1 and INV2 may be 2-level or multi-level inverters.

In embodiments, the higher-level control system 86 may be an electric motor control or similar. It can also include a common PWM generation function (for example, a PWM modulator) for all system elements and phases.

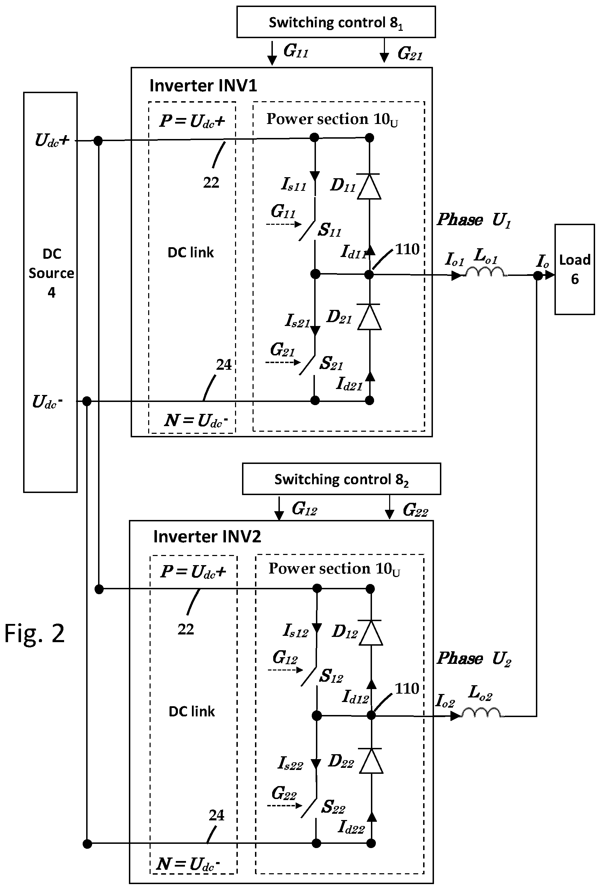

The schematic of an exemplary inverter system (e.g., single-phase inverter system) having two so-called hard-switching inverters INV1 and INV2 connected in parallel is illustrated in Fig. 2 and described herein in order to alleviate comprehending operation and configuration of embodiments of the invention in relation to exemplary basic parallel-connected inverters. It is not intended to limit embodiments of the invention to the described and illustrated exemplary inverters. It shall be appreciated that the current sharing control according to embodiments of the invention is universally applicable to any number of parallel inverters, any type of inverters and their derivates and modifications regardless the specific design, configuration, and operation variations of an inverter from the exemplary inverter. For examples, the current sharing control according to embodiments of the invention is applicable to so-called soft-switching inverters.

The parallel-connected inverters INV1 and INV2 may preferably be identical inverters having the same configuration and operation. The inverters INV1 and INV2 comprise power switching sections 10, such as half-bridge circuits, and dc-link rails 22 (positive dc-link potentials P) are connected to a first voltage terminal U_{dc+} of the common DC power source 4, and dc-link rails 24 (negative dc-link potentials N) are connected to a second voltage terminal U_{dc-} of the common DC power source 4. The DC link may include one or more DC link capacitors for temporarily storing energy. The output node 110 of each power switching section 10 can be connected through the corresponding output inductance Lₒ₁ and Lₒ₂ to the corresponding phase terminal of an ac load 6, such as an ac motor or ac grid or any applicable electric load, and thereby the corresponding phase outputs 110 of the inverters INV1 and INV2 (e.g., phase legs U₁ and U₂) are connected in parallel via Lₒ₁ and Lₒ₂. It should be appreciated that although a half-bridge inverter is illustrated as an example herein, the inverter may have other configurations, particularly a full-bridge configuration.

The exemplary half-bridge power section 10u of the inverter INV1 illustrated in Fig. 2 includes a pair of main or power switching devices S₁₁ and S₂₁ coupled in parallel to the dc-link rails 22 and 24. The first (upper) main switching device S₁₁ may have a first terminal electrically coupled to the positive dc-link rail 22 and a second terminal electrically coupled to an output node 110. The second (lower) main switching device S₂₁ having a first terminal coupled to output node 110 and a second terminal coupled to the negative dc-link rail 24. Across the upper main switching device S₁₁ between the positive dc-link rail 22 and the output node 110 is connected a first antiparallel diode D₁₁, also called a freewheeling diode or zero diode. Across the lower main switching device S₂₁ between the output node 110 and the negative dc-link rail 24 is connected a second antiparallel diode D₂₁. The upper main switching device S₂₁ is operable to turn on and turn off, and thereby to respectively connect and disconnect the dc-link rail 22 and the output node 110, in response to control signal(s) G₁₁ received from a control and driver circuitry, such as an inverter-specific switching controller 8₁ illustrated in Fig. 2. The lower main switching device S₂₁ is operable to turn on and turn off, and thereby to respectively connect and disconnect the dc-link rail 24 and the output node 110, in response to control signal(s) G₂₁ received from the control and driver circuitry, such as the switching controller 8₁. Similarly, the exemplary half-bridge power section 10u of the inverter INV2 illustrated in Fig. 2 includes a pair of main or power switching devices S₁₂ and S₂₂, a first antiparallel diode D₁₂, a second antiparallel diode D₂₂, and switching control signals G₁₂ and G₂₂ from a control and driver circuitry, such as an inverter-specific switching controller 8₂.

The switching control 8₁...8ₙ illustrated in Figs. 1 and 2 refers generally to any control functions, logic, hardware, firmware, software, etc. required to control switching devices in the hard-switching or soft-switching phase leg(s) based on a PWM signal or PWM signals. In embodiments, at least lower levels of the switching control may be implemented by a programmable logic, such as Field Programmable Gate Arrays (FPGAs). Given a PWM signal, a standard hard-switching inverter does not need too much additional logic to form a complete inverter drive system. At a minimum, the direct PWM signal is sent to control one switch while the complement of the PWM input signal is sent to control the other switch in that phase. The soft switching, on the other hand, may require an additional more complex control.

By complementarily turning on and off the upper and lower switches S₁₁ and S₁₂ as well as S₂₁ and Szz, the output current Iₒ will be commutated between the upper part and lower part of the power section 10 in different ways depending on the sign (direction) of the output current and the direction of the output voltage swing. If the output current Iₒ is positive (Iₒ > 0) and the output voltage Uₒ swings from the potential N (the dc-link 24) to the potential P (the dc-link 22), the lower diodes D₂₁ and D₂₂ commutate their currents (Id₂₁ and Idzz, respectively) to upper switches S₁₁ and S₁₂, respectively. If the output current Io is negative (Iₒ < 0) and the output voltage Uₒ swings from the potential P (the dc-link 22) to the potential N (the dc-link 24), the upper diodes D₁₁ and D₁₂ commutate their currents (Id₁₁ and Id₁₂, respectively) to lower switches S₂₁ and S₂₂, respectively. If the output current Iₒ is positive (Iₒ > 0) and the output voltage Uₒ swings from the potential P (the dc-link 22) to the potential N (the dc-link 24), the upper switches S₁₁ and S₁₂ commutate their currents to lower diodes D₂₁ and D₂₂, respectively. If the output current Iₒ is negative (Io < 0) and the output voltage Uₒ swings from the potential N (the dc-link 24) to the potential P (the dc-link 22), the lower switches S₂₁ and S₂₂ commutate their currents to diodes D₁₁ and D₁₂, respectively.

The commutation for a corresponding phase in the plurality of parallel-connected inverters can be initiated by similar commutation commands at the same time instant. For example, the commutation for phase V₁ of the inverter INV1 and the phase V₂ of the inverter INV2 can be initiated by similar commutation commands at the time instant tₒ. In an ideal case, when the current sharing is in balance, the output currents Iₒ₁ and Iₒ₂ of the parallel-connected inverters (e.g., phase legs U₁ and U₂ in Fig. 2) would be equal and their difference or a differential output current I_{do} would be zero, (e.g., I_{do} = Iₒ₁ - Iₒ₂ = 0). However, the ideal behavior during commutations would require that the corresponding switches, e.g., S₁₁ and S₁₂, in the parallel operated inverters turn on at the same instant when commutating the output potential Uₒ, for example from N to P. Likewise, they should turn off at the same instant when commutating the output potential from P to N. Unfortunately, the parallel operated inverters do not behave similarly, for example due to parameter differences of switch components, differences in operation conditions, and differing impedances in parallel branches, the output currents from the parallel inverters can be unequal in value. In other words, there can be uneven current sharing between the inverters. Due to thermal and economic reasons, it is of utmost importance that the parallel-connected inverters share the load current as evenly as possible.

In embodiments, the semiconductor switching devices, such as S₁₁, S₁₂, S₂₁ and S₂₂ in the illustrated examples, may be insulated gate bipolar transistors (IGBT), reverse conducting IGBTs (RC-IGBT), metal-oxide-semiconductor field-effect transistors (MOSFET), or silicon carbide (SiC) MOSFETs to name several examples. MOSFET is a voltage-controlled semiconductor switching component, in which a voltage applied to a gate controls a voltage and a current flow between a source and a drain, the MOSFET will start conducting through the drain and source pins. IGBT is a switching component with two characteristics: high-power as bipolar transistor, high-speed converting and voltage driven as MOSFET. A voltage applied to a gate controls a voltage and a current flow between a collector and an emitter. MOSFET and IGBT have similar input characteristics with some parasitic capacitances, such as a gate capacitance and an input capacitance. These capacitances have great effects on the behaviours of the semiconductor switch during a switching period.

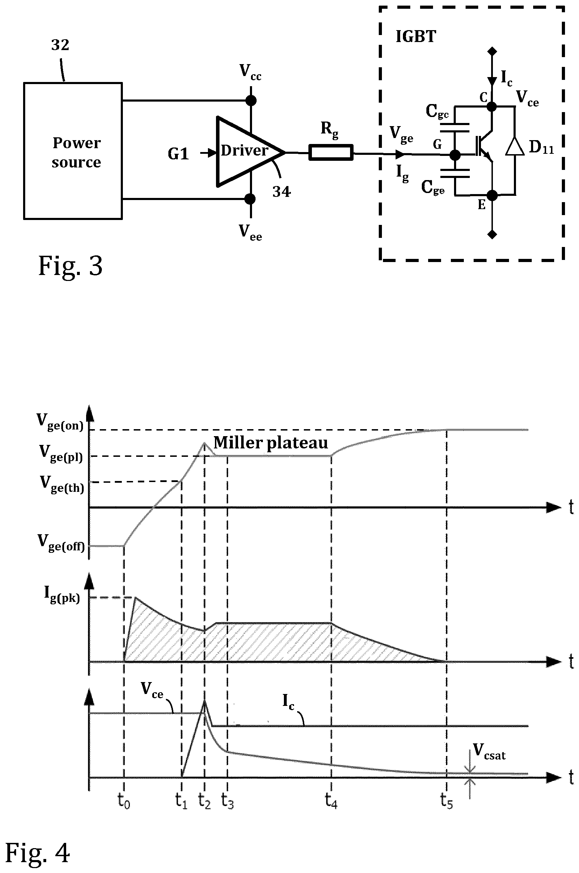

Typically, a gate driver circuit is provided to control the gate voltage of a semiconductor switching device based on a gating signal or a switching control signal. In the most common gate control technology, the gate voltage of the IGBT or MOSFET is controlled by a gate resistor and a bipolar voltage source. The bipolar voltage source may be ±15 V, for example. An example of a gate driving control 34 using a bipolar voltage source (V_{cc}, Vₑₑ) 32 and a gate resistor R_{g} is illustrated in Fig. 3. In the example, it is assumed that the switching device S₁₁ is implemented by IGBT provided with an antiparallel diode D₁₁. An output voltage of the gate driving control 34 connected via the gate resistor R_{g} to a gate G of the IGBT. The switching of the gate driving control 14 is controlled by one or more control or gating signals G₁₁. In embodiments, the one or more control or gating signals are pulse width modulated (PWM) signals. The output of the gate driving control 14, and thereby a gate voltage may be alternately switched to the voltage V_{cc} and Vₑₑ (e.g., ±15 V) according to the one or more control or gating signals G₁₁. This kind of so-called "voltage source" gate driver is commonly used, wherein the gate power source behaves like a voltage source to charge and discharge the gate of the semiconductor power switching device. It shall be appreciated that an implementation of the gate driving circuit, such as the circuit 14, is not essential to embodiments of invention. A gate driving voltage or current may be generated by any gate driving arrangement.

The turn-on and turn-off of the IGBT depend on a gate voltage (gate-emitter voltage) V_{ge} between a gate G and an emitter E of the IGBT. The input capacitance of the IGBT consists of two nonlinear components that are commonly called the gate capacitance (C_{ge}) and the gate-collector (Miller) capacitance (C_{ge}). The input capacitance of the IGBT may be defined by the parallel connected gate-emitter capacitance C_{ge} and gate-collector Ccg capacitance, Cᵢₑₛ = C_{ge} + C_{cg}. The parasitic capacitances are inherent features of the IGBT, and they may vary from one component to another. Gate driver circuits are typically arranged to charge and discharge the gate capacitance C_{ge} (or generally the input capacitance Cᵢₑₛ) so as to switch on and off the IGBT according to the control or gating signal(s) G₁₁. The switching characteristics of the semiconductor switching device can be controlled by the dimensioning of the gate circuit. The magnitude of the gate current Ig, i.e. the charging and discharging rate of the gate charge, can be controlled by varying magnitudes of the gate driver voltage Vcc/Vee, the gate voltage V_{ge}, the gate resistor R_{g}.

Fig. 4 shows an example of IGBT switching waveforms in the turn-on for a power inverter, such as the inverter INV1 shown in Fig. 2. Let us assume that the upper switch S₁₁ with an antiparallel freewheeling diode D₁₁ in the power section 10ᵤ (a half bridge) is implemented with the IGBT and a gate driver circuit as shown in Fig. 3, and the lower switch S₂₁ with an antiparallel freewheeling diode D₂₁ is implemented similarly. The upper IGBT S₁₁ is controlled by a first gate driver and the lower IGBT S₂₁ is controlled by a second gate driver. The half-bridge 10ᵤ is arranged to drive a load 6 with a load current I_{L}. It is assumed that the switching waveforms illustrated in Fig. 4 are for the lower IGBT S₂₁, and that prior to the time instant t0, the lower IGBT S₂₁ is in off-state with a gate voltage V_{ge}(off) at the gate G, while a freewheeling current (equal to the load current I_{L}) flows via the upper freewheeling diode D₁₁.

At time instant t₀, the gate driver 14 of the lower IGBT S₂₁ receives a turn-on signal from a control circuitry. The gate driver 14 starts to charge the gate capacitance C_{ge} by the gate current I_{g}, and the gate voltage V_{ge} starts to rise. During the interval t₀-t₁, which is also called a dead time, only the gate capacitor C_{ge} At this stage, the collector has no current and the pole voltage has not changed.

At time instant t₁, the gate voltage V_{ge} rises to the turn-on threshold voltage V_{ge}(th), and the commutation of the collector current Ic starts. The gate current I_{g} charges the C_{ge} and C_{gc} capacitances, the IGBT S₂₁ starts to open, the collector current I_{c} begins to increase, and the gate voltage V_{ge} continues increasing. The commutation of the collector current I_{c} ends at time instant t₂ when the gate voltage V_{ge} reaches a certain value in which the gate voltage is maintained at a level, which is called the Miller plateau voltage V_{ge}(pl). The Miller plateau voltage, in turn, depends on the characteristics of the IGBT S₂₁ used and the magnitude of the current I_{c} to be commutated. The higher the current, the higher the Miller voltage. As the collector current Ic increases, the freewheeling current through the upper freewheeling diode D2 decreases and finally ends. The peak shown in the collector current Ic is due to the reverse recovery current of the upper freewheeling diode D₁₁ flowing for a short time after the Miller voltage has been reached. The IGBT S₂₁ takes over both the reverse current of the freewheeling diode D₁₁ and the load current. At time instant t₂, the reverse recovery current of the upper freewheeling diode D₁₁ has ended, and the collector current I_{c} starts settle to a value corresponding to theoutput current Iₒ The reverse recovery current of D₁₁ also causes a peak to the gate voltage V_{ge}. The collector-emitter voltage U_{ce} decreases rapidly between time instants t₂ - t₃. The gate current I_{g} charging the C_{ge} and C_{gc} capacitances. At time instant t₃, the gate voltage V_{ge} settles to the Miller voltage. After time instant t₃, since the collector-emitter voltage U_{ce} decreases gradually towards the saturation voltage V_{csat}, the gate voltage V_{ge} does not rise but will stay approximately constant. At time instant t₄, the gate current I_{g} continues to charge the C_{ge} capacitance, the gate voltage V_{ge} begins to rise again. Finally, at time instant t₅, the gate voltage reaches the V_{ge}(on) level, the collector-emitter voltage V_{ce} reaches the saturation voltage V_{csat}, and the entire IGBT S₂₁ is fully turned on.

Embodiments of the invention focus on a conducting state of the semiconductor power switching device, such IGBT, and the current sharing of parallel connected inverter legs during the conducting state. In the example illustrated in Fig. 4, the conducting state of the IGBT begins at the time instant t₁.

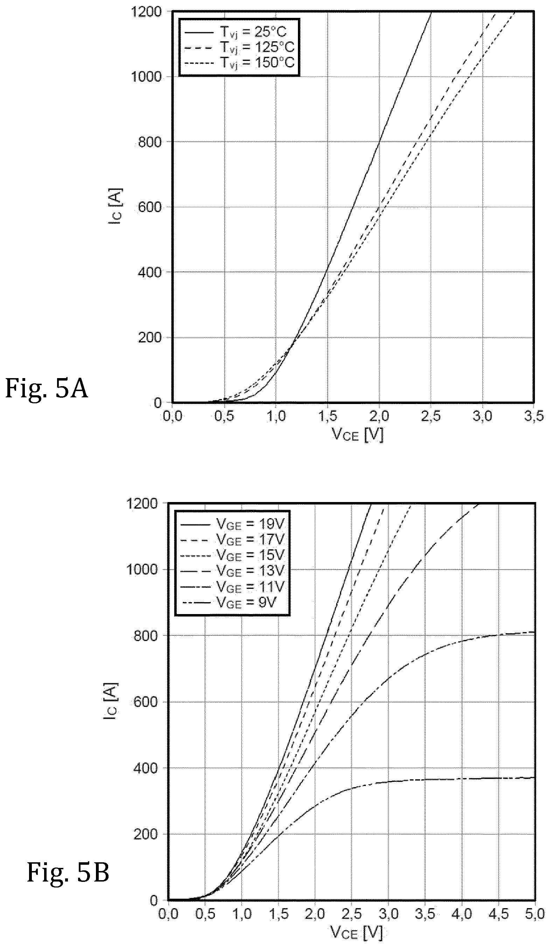

Parallel connected inverter legs, such as INV1 and INV2 may have uneven current sharing as the electrical parameters on the current paths may be different due to device differences or operating condition differences. For example, the electrical parameters may be different due to different operating temperatures. Fig. 5A shows an example of a typical collector-emitter voltage V_{ce} on the collector current I_{c} at different IGBT chip temperatures Tᵥⱼ while the gate voltage V_{ge} is constant. Fig. 5B shows an example of a dependency of the collector-emitter voltage V_{ce} on the collector current I_{c} with different gate voltages V_{ge} while the chip temperature Tᵥⱼ is constant. It can be seen that when the IGBT is on, the collector-emitter voltage V_{CE} changes in accordance with the collector current I_{C}, the gate voltage V_{ge}, and the temperature Tⱼ. The collector-emitter voltage V_{CE} increases in direct proportion to the collector current I_{c} and inversely proportional to the gate voltage V_{ge} value.

The smaller the collector-emitter voltage V_{ce} value, the lower is the power dissipation loss of the IGBT. Therefore, for the power loss minimization, it would be beneficial to have relatively high gate voltage V_{ge} to keep the collector-emitter voltage V_{ce} low at high collector currents I_{c}. However, for the parallel connected legs, this leads to uneven current sharing as the lower collector-emitter voltage tends to draw more current. Higher current will increase both conduction and switching losses of the device, thus causing extra stress on the device.

According to an aspect of the invention a current sharing between the parallel-connected converter legs can be balanced by means of having an individual autonomous leg-specific gate voltage adjustment for the semiconductor power switching devices of each of parallel connected converter legs in function of the leg current of the respective inverter leg. By means of the autonomous leg-specific adjustment of the gate voltage (or a gate charge in general) of the semiconductor switching device, the collector-emitter voltage of the semiconductor switching device can be essentially manipulated as function of its own leg-specific current or current related information to balance the leg currents between two or more parallel-connected legs. The autonomous gate voltage adjustment of each parallel-connected leg is configured to adjust the gate voltage in a direction and/or by an amount that the leg currents of the parallel-connected legs will change towards each other.

Advantageously, the parallel inverter legs do not need to know about each other's currents or the differential current, but the balanced current sharing by adjusting gate voltage can be embodied relying only on information that is readily available separately in each of the parallel-connected legs, i.e. output current value (e.g., Iₒ₁ or Iₒ₂). The benefit of an autonomous (or distributed or decentralized) control stems from avoiding the need for information exchange between higher-level control and lower-level control entities or between the lower-level control entities, such as the switching controls 8₁ and 8z. The autonomous control system is usually also simpler and more modular compared to a centralized one, thus it is easier to understand and maintain. Further, to keep the implementation cost effective, it would be preferable that there would not be any extra requirements for component selection or communication needs between the parallel-connected inverter units, i.e., the normal "single inverter units", such as the inverters INV1 and INV2, could be parallel as such. The challenge on the other hand is obvious: the autonomous units must operate with limited information. This challenge is overcome with embodiments of the present invention.

In embodiments, the autonomous leg-specific gate voltage adjustment is essentially done inversely proportional to the leg-specific current or current-related information. In other words, at higher current values the gate voltage is lower, while at lower current values the gate voltage is higher. More precisely, the gate voltage may have an increased value when the leg current is having a lower value and similarly, the gate voltage may have decreased value when the leg current is having a higher value. For example, the gate voltage may increase linearly or stepwise with the leg current.

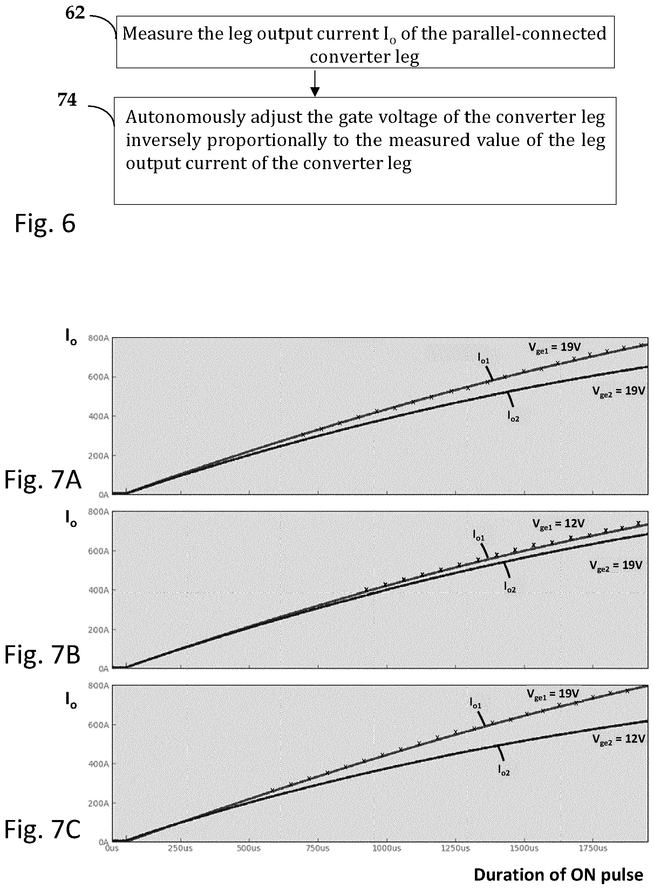

In embodiments, a current sharing between the plurality of parallel-connected converter legs is balanced by a control arrangement, such as the switching controls 8₁ and 8₂ in Figs, 1 and 2. Fig. 6 shows a flow diagram illustrating an exemplary operation of the control arrangement. The control arrangement may sense the leg output current Iₒ in each of the parallel-connected converter legs (step 62) and autonomously adjust the gate voltages of the respective converter leg inversely proportionally to the leg-specific current to the value of the sensed leg current of the respective converter leg (step 64).

Let us examine an operational example of the balancing method according to an embodiment. In the example, two essentially similar semiconductor switch modules, e.g., S₁₁+S₂₁ and S₁₂+S₂₂ of phase legs U₁ and U₂ in Fig. 2, are connected in parallel through leg specific inductors, e.g., Lₒ₁ and Lₒ₂ in Fig. 2. The semiconductor modules S₁₁+S₂₁ and S₁₂+S₂₂ are driven with gate voltages V_{ge1} and V_{ge2}, respectively. Figures 7A, 7B and 7C are graphs that illustrate the behavior of the leg currents Iₒ₁ and I₀₂ with different gate voltages in function of the duration of the turn-on pulse of the gating or control signals, such as G₁₁, G₂₁, G₁₂, and G₂₂ in Fig. 2, applied to the parallel-connected semiconductor switch modules S₁₁+S₂₁ and S₁₂+S₂₂. In other words, the duration of the ON pulse may represent the duty cycle of the PWM signal defining the target output leg current. First, Fig. 7A shows a situation where the semiconductor modules S₁₁+S₂₁ and S₁₂+S₂₂ of both legs U₁ and U₂ are driven with same gate voltage values (V_{ge1} = +19V, V_{ge2} = +19V) and the two leg currents Iₒ₁ and I₀₂ are deviating from each other. In other words, there is imbalance in the current sharing between the legs U₁ and U₂, the leg U₁ having the higher leg current Iₒ₁, and the leg U₂ having the lower leg current Iₒ₂. Then, Fig. 7B shows a situation where the gate voltages of legs U₁ and U₂ are adjusted in accordance with an embodiment of the invention, i.e. inversely proportional to the leg specific current, so that the higher current leg U₁ is driven with a lower gate voltage (V_{ge1} = +12V) and the lower current leg U₂ with a higher gate voltage (V_{ge2} = +19V). This results in more balanced output currents Lₒ₁ and Lₒ₂ for the two legs U₁ and U₂ as the leg currents have moved towards each other in relation to Fig. 7A. Finally, for comparative purposes, Fig. 7C shows a situation where the gate voltages are adjusted in opposite directions compared to Fig. 7B, i.e., directly proportional to the leg specific current, so that the higher current leg U₁ with a higher gate voltage (V_{ge1} = +19V) and the lower current leg U₂ with a lower gate voltage (V_{ge2} = +12V). This results in the excessive current deviation and increased current imbalance as the leg currents have moved farther from each other as compared to Fig. 7A.

In a typical case the the parallel-connected converter legs have similar nominal leg current ratings. In embodiments, the autonomous leg-specific gate voltage adjustment of all parallel-connected converter legs have the same first predetermined dependence on the value of the sensed leg current of the respective converter leg.

However, the the autonomous leg-specific gate voltage adjustment of the invention can be applied also in a case the parallel connected phase legs have different nominal current ratings. In embodiments, predetermined first and second dependences of different parallel-connected converter legs having different nominal leg current ratings are selected to scale the current sharing between the between the parallel-connected converter legs according to nominal leg currents of the parallel-connected converter legs.

As noted above, the current sharing is based on leg specific current related information. The current sharing can be done by adjusting the gate voltage(s) of one or more converter legs proportional to leg current related information of the corresponding leg, i.e., V_{ge} = f(current). As used herein, the current related information may relate to any measurement or feedback information or signal that varies in proportion to the leg current in question. The current related information or signal can be in the form of a current, a voltage or a temperature but not limited to these.

In embodiments, the current related information may be a leg current sensed and provided to a controller by any suitable current sensing arrangement, e.g., a shunt resistor, a Hall effect sensor, or a current transformer provided at output of the respective converter leg. Alternatively, leg-specific current related information may be derived or calculated from one or more other sensed quantities of the corresponding converter leg.

In embodiments, the current sharing may include adjusting the gate voltage of the leg proportional to current related information and other parameter(s) of the corresponding leg, like ambient temperature, or transistor module temperature, i.e., V_{ge} = f(current, parameters). In embodiments, one or more further sensors may be provided to measure such other parameters, if required, such as temperature sensors.

In embodiments, predefined gate voltage control values may be stored in a memory for such other parameter(s), e.g., in tabular format. In embodiments, instead of or in addition to predefined control values, the gate voltage control values may be calculated or determined in fly by a control algorithm.

In embodiments, the gate voltage may be adjusted differently in function of time, i.e., V_{ge} = f(current, time). In embodiments, the gate voltage may have pre-defined periods of different gate voltage levels, i.e., V_{ge} = f(current, parameters, time).

In embodiments, control dynamics, range and activation/deactivation of the autonomous gate voltage adjustment can be dependent on system parameters, like the leg specific current, semiconductor temperature, ambient temperature, etc.

In embodiments, control parametrization of the autonomous gate voltage adjustment can be made according to leg specific ratings, e.g. related to a nominal current of the corresponding leg.

The current sharing according to embodiments of the invention can be used with any semiconductor switching devices having a controllable channel structure. Nonlimiting examples of such semiconductor devices include IGBT, MOSFET, RC-IGBT, IGBT and MOSFET connected in parallel, etc. When using IGBT, the gate voltage control affects only with a unipolar channel current, while with MOSFET and RC-IGBT the gate voltage control affects to a bipolar channel current.

The gate voltage can be controlled by any suitable gate driver circuitry, such as a PWM gate driver, a current source gate driver, a variable voltage gate driver, etc.

Examples of the suitable gate driver concepts are presented in EP3179632B1, EP2178211B1, and in the IP.com Prior Art Database Technical Disclosure No. IPCOM000250364D, Power Semiconductor Control, Kittilä Jukka-Pekka et al, IP.com Prior Art Database, 06.07.2017, http://ip.com/IP-COM/000250364.

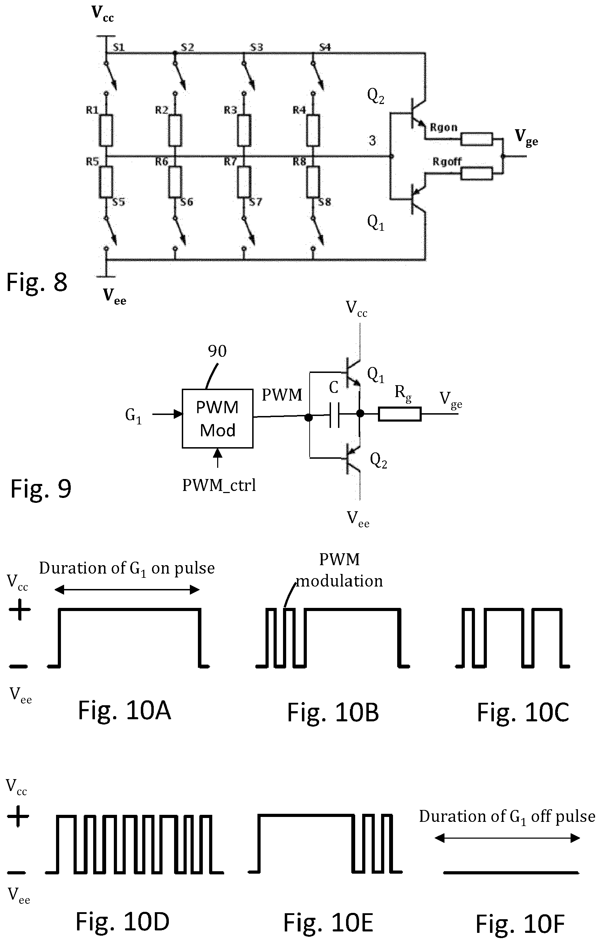

In EP3179632B1, a modification of the control signal of the output stage of the gate driver, and thereby the gate voltage to an IGBT, is implemented by using a resistor matrix as illustrated in Fig. 8A The exemplary gate driver circuit comprises a plurality of series connections of controllable switches S1 ...S8 and resistive components R1 ...R8. A first part of the plurality of series connections is connected between the positive voltage rail V_{cc} and control input 3 of the output stage Q1 and Q2. Four series connections S1, R1; S2, R2; S3, R3; S4, R4 of resistors and controllable switches are connected between V_{cc} and the control input 3 of the output stage Q1 and Q2. Similarly, a second part of the plurality of series connections S5, R5; S6, R6; S7, R7; S8, R8 is connected between the negative voltage rail Vₑₑ and control input 3 of the output stage Q 1 and Q2. The controllable switches are controlled such that a desired voltage is obtained to the control electrodes of the output switches Q1 and Q2. The state of the controllable switches set the potential that is applied to the control electrodes of the output switches Q1 and Q2 when the voltages V_{cc} and Vₑₑ and the values of the resistors are fixed. The output voltage, i.e., the gate voltage V_{ge}, from the gate driver circuit is between the voltages V_{cc} and Vₑₑ. Thus, the controllable switches enable to select different combinations of active resistors such that different gate voltage V_{ge} levels are achievable by selecting differing combinations. It is possible to have many different gate voltage Vge levels during a device switching period, including the turn-on, conducting and turn-off durations.

EP2178211B1 and IPCOM000250364D both disclose a gate driver that utilizes a pulse-width-modulation (PWM) to generate a desired average gate voltage V_{ge} for a given period of time. A simplified schematic diagram of an exemplary gate driver circuit is shown Fig. 9. Now the output stage Q₁ and Q₂ of the gate driver is controlled with a PWM signal. With a PWM signal, an instantaneous time average of the output of the output stage can be adjusted practically in an unlimited manner within a range defined by available operating voltage levels V_{cc} and Vₑₑ. The desired average gate voltage may be formed to a gate-emitter capacitor C connected to between gates and emitters of the output transistors Q₁ and Q₂ to for its part to slow down the dynamic of the output transistors and filter the high-frequency signal from the outputted gate voltage signal.

The PWM signal may be a PWM gating or control signal, e.g., G₁ in Fig. 2, which is modulated by a higher frequency PWM signal, e.g., by a modulator 90. In embodiments, the PWM signal may be obtained directly from a control logic, such as the switching control 8₁ or 8₂. The PWM modulation and thereby the level of the gate voltage V_{ge} may be controlled by suitable control signal(s) or value(s) represented generally by a signal PWM_ctrl in Fig. 9.

Some illustrative exemplary PWM signals for gate-emitter voltage control are shown in Figs. 10A-10F. Fig. 10A illustrates an unmodulated ON pulse of a gating signal, e.g., G₁, and Fig. 10F illustrates an unmodulated OFF pulse of a gating signal. When the higher frequency PMW pulsing is located in the early part of the gating pulse, as illustrated in Fig. 10B, the turn-on behavior of the power semiconductor (e.g., IGBT) can be affected. When the pulsing is located at the end of the gating pulse, as illustrated in Fig. 10E, the turn-off behavior of the power semiconductor (e.g., IGBT) can be affected. If the pulsing is performed throughout the duration of the gating pulse, as illustrated in Figs. 10C and 10D, it is possible to affect also the behavior of the on-state in addition to the on/off changes.

Alternatively, it may be said that the ON duration of the gating signal, e.g., G₁ in Fig. 2, consists of one pulse (Fig. 10A) or several consecutive pulses (Figs. 10B-10E) of different lengths. The operation of the PWM circuit can be constant-frequency or variable-frequency, i.e. the intervals between the pulses can change. The lengths of the pulses can be varied in a desired manner between 0...100% depending on the performance capacity of the electronics used, for example. The lengths and/or frequencies of the pulses can be changed, or they can be set constant to predetermined values, for instance.

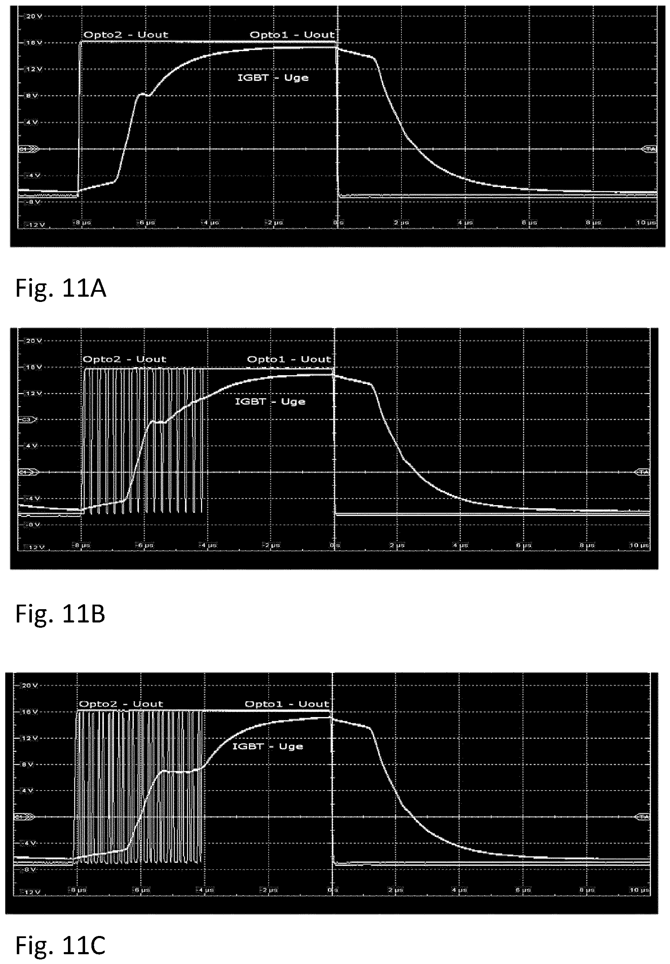

Figs. 11A-11C show some example waveforms of the gate voltage V_{ge} illustrating the effect of the PWM control of gate voltage during a turn-on switching of an IGBT. The rectangular wave (designated Opto1 - Uout) having a rising edge at about -8 µs and a falling edge at about 0 s represents a gating ON pulse, e.g., G₁, with a duration of about 8 µs. The curve IGBT-Uge illustrates the resulting gate voltage V_{ge} in function of time. The higher frequency rectangular wave (designated Opto2 - Uout) represents a PWM pulsing of the gating ON pulse. In Fig. 11A, no higher frequency is added to the gating ON pulse so that it has its original rectangular shape. In Fig. 11B, a higher frequency PWM pulsing is added in the first half of the gating ON pulse, between -8 µs and -4 µs, which results in lower gate voltage levels and and lower rate of the gate voltage change over time, du/dt. In Fig. 11C, the frequency of the PWM pulsing added in the first half of the gating ON pulse has been increased, which further lowers the gate voltage levels and the rate of the gate voltage change over time, du/dt.

The gate driver control, such as the switching control 8₁ and 8₂ or the higher-level control system 86, controlling the gate voltage in accordance embodiments of the invention may be implemented by various means. For example, these techniques may be implemented in hardware (one or more devices), firmware (one or more devices), software (one or more modules), or combinations thereof. For a firmware or software, implementation can be through modules (e.g., procedures, functions, and so on) that perform the functions described herein. The software codes may be stored in any suitable, processor/computer-readable data storage medium(s) or memory unit(s) and executed by one or more processors/computers. The data storage medium or the memory unit may be implemented within the processor/computer or external to the processor/computer, in which case it can be communicatively coupled to the processor/computer via various means as is known in the art. In embodiments, at least lower levels of the switching control may be implemented by a programmable logic, such as Field Programmable Gate Arrays (FPGAs).

The description and the related drawings are only intended to illustrate the principles of the present invention by means of examples. Various alternative embodiments, variations and changes are obvious to a person skilled in the art on the basis of this description. The present invention is not intended to be limited to the examples described herein but the invention may vary within the scope and spirit of the appended claims.

## Claims

1. A power converter system, comprising
two or more converter legs connected in parallel between a common dc system and a common ac system or between two common dc systems to provide respective two or more leg currents, wherein each of said converter legs comprises one or more controllable semiconductor power switching devices,
a gate driver circuitry coupled to provide dedicated gate voltages to gates of the controllable semiconductor power switching devices, and
a control arrangement configured to balance a current sharing between the parallel-connected converter legs by means of having an individual autonomous leg-specific gate voltage adjustment for the controllable semiconductor power switching devices of each of parallel connected converter legs in function of the leg current or leg-current-related information of the respective converter leg.

2. The power converter system as claimed in claim 1, wherein the autonomous gate voltage adjustment of each parallel-connected leg is configured to adjust the gate voltage in a direction and/or by an amount that the leg currents of the parallel-connected legs will change towards each other.

3. The power converter system as claimed in claim 1 or 2, wherein the autonomous gate voltage adjustment of each parallel-connected leg is configured to rely only on leg-current-related information that is available in the respective parallel-connected leg without information exchange between the autonomous gate voltage adjustments of the parallel-connected legs.

4. The power converter system as claimed in any one of preceding claims, wherein the autonomous gate voltage adjustment of each parallel-connected leg is configured to adjust the gate voltage inversely proportional to the leg-specific current or leg-current-related information.

5. The power converter system as claimed in any one of preceding claims, wherein the autonomous gate voltage adjustment of each parallel-connected leg is configured to decrease the gate voltage with increasing leg current and to increase the gate voltage with decreasing leg current.

6. The power converter system as claimed in any one of preceding claims, wherein the autonomous leg-specific gate voltage adjustments of all parallel-connected converter legs have the same first predetermined dependence on the value of the sensed leg current of the respective converter leg.

7. The power converter system as claimed in any one of preceding claims, wherein at least two of the parallel-connected converter legs have different nominal leg current ratings, and wherein the at least two parallel-connected converter legs with different nominal leg current ratings have different predetermined dependences on the value of the leg current of the respective converter leg that are configured to scale the current sharing between the between the at least two parallel-connected converter legs according to the nominal leg current ratings.

8. The power converter system as claimed in any one of preceding claims, wherein the leg current related information comprises a sensed leg current, or information derived or calculated from one or more other sensed quantities of the respective parallel-connected converter leg.

9. The power converter system as claimed in any one of preceding claims, wherein the autonomous gate voltage adjustment of each parallel-connected leg is configured to adjust the gate voltage in function of the leg current or leg-current-related information of the respective converter leg and further in function of one or more other parameters of the respective converter leg.

10. The power converter system as claimed in any one of preceding claims, wherein the autonomous gate voltage adjustment of each parallel-connected leg is configured to adjust the gate voltage differently in function of time.

11. The power converter system as claimed in any one of preceding claims, wherein the gate voltage may have pre-defined periods of different gate voltage levels.

12. The power converter system as claimed in any one of preceding claims, wherein the control arrangement is configured to set control dynamics, control range, activation and/or deactivation of the autonomous gate voltage adjustment dependent on system parameters.

13. The power converter system as claimed in any one of preceding claims, wherein the controllable semiconductor power switching devices comprises one or more of an insulated gate bipolar transistor (IGBT), a reverse conducting IGBT (RC-IGBT), metal-oxide-semiconductor field-effect transistor (MOSFET), or a silicon carbide (SiC) MOSFET.

14. The power converter system as claimed in any one of preceding claims, wherein the control arrangement comprises a leg-specific controller for each of the two or more parallel-connected converter legs to adjust the gate voltages.

15. The power converter system as claimed in any one of preceding claims, wherein each of the converter legs comprises one or more controllable semiconductor power switching devices in a full bridge configuration, a half bride configuration, or a chopper configuration.

16. The power converter system as claimed in any one of preceding claims, wherein the converter legs form a multi-level converter.

17. The power converter system as claimed in any one of preceding claims, wherein the power converter system comprises two or more converters, each of the converters comprising one or more converter legs, wherein the parallel-connected converter legs are the corresponding converter legs of the two or more converters connected in parallel.

18. The power inverter system as claimed in claim 17, wherein the control arrangement comprises converter-specific switching controllers for the two or more converters, each of the converter-specific switching controllers being configured to provide the autonomous adjustment of the gate voltages for each of the converter legs of the respective converter.
